# EUROPEAN PATENT APPLICATION

(11) **EP 3 681 258 A1**
(43) Date of publication of application: **15.07.2020**
(21) Application number: 17924222.7
(22) Date of filing: 08.09.2017
(51) Int. Cl.: H05K 7/20

(54) **CONTROL DEVICE FOR POWER SYSTEM OF ELECTRIC VEHICLE**

(71) Applicant: Hunan CRRC Times Electric Vehicle Co., Ltd, Zhuzhou, Hunan 412007 (CN)
(72) Inventor: LIU, Ling, Zhuzhou Hunan 412007 (CN); WANG, Wei, Zhuzhou Hunan 412007 (CN); TANG, Guangdi, Zhuzhou Hunan 412007 (CN); WANG, Qianchao, Zhuzhou Hunan 412007 (CN); YAN, Yanmao, Zhuzhou Hunan 412007 (CN); ZENG, Peng, Zhuzhou Hunan 412007 (CN); YANG, Hongbo, Zhuzhou Hunan 412007 (CN); PENG, Zaiwu, Zhuzhou Hunan 412007 (CN); WANG, Zhengyu, Zhuzhou Hunan 412007 (CN); CHEN, Zhu, Zhuzhou Hunan 412007 (CN); ZHU, Chenhan, Zhuzhou Hunan 412007 (CN); ZHENG, Chunlong, Zhuzhou Hunan 412007 (CN)
(74) Representative: Laine IP Oy
(86) International application number: PCT/CN2017/100994
(87) International publication number: WO 2019/047144

(57) **Abstract**

Disclosed is a control device for a power system of an electric vehicle, comprising: a casing (1) having a cavity formed therein; a heat dissipation plate (2) arranged in the cavity to divide the cavity into an upper chamber (3) and a lower chamber (4); a DC-DC module (5) and a capacitance assembly (6) both arranged in the lower chamber (4) and abutted against the heat dissipation plate (2); a plurality of module assemblies (7) arranged in the upper chamber (3) and abutted against the heat dissipation plate (2); and a wiring interface, having a main body arranged in the upper chamber (3) and being configured to provide an interface for being connected to other module assemblies. The device is integrated with core components of the electric vehicle in a compact structure, is small in size and convenient to install and maintain, and has high practical value and promotional value compared with the prior arts.

## Description

### Technical Field

The present invention relates to the field of electronic technology, particularly to a control device for a power system of an electric vehicle.

### Technical Background

With the increasing requirements on energy conservation and environmental protection, new energy vehicles, such as electric vehicles, are becoming more and more popular in markets.

The power control system of an electric vehicle includes many core components. Because these components are independent from each other, they are often arranged at different locations of the vehicle in a stacking manner. This arrangement leads to difficulties of installation and maintenance of these components, and also occupies a huge proportion of vehicle in terms of space and weight. Therefore, the production and assembly of the whole vehicle suffer heavy workload, and thus the production cost is significantly increased. Moreover, various wires are connected between these core components in a criss-cross manner, so that the problem of signal interference is serious due to poor electromagnetic compatibility between these components. Therefore, safe operation of the vehicle is severely affected.

Therefore, a unified and integrated design for the power control system of the vehicle is needed to optimize the layout thereof, by which electromagnetic interference can be mitigated, and the number of the vehicle's parts and components can be reduced. In this manner, most of functional requirements of the vehicle can be met by one single installation of components, the space volume and weight are reduced, the production and maintenance costs are decreased, and the reliability of the vehicle is improved.

### Summary of the Invention

The present invention proposes a control device for a power system of an electric vehicle, including: a casing, which is configured to have a box structure with a cavity formed therein; a heat dissipation plate, which is arranged in the cavity to divide the cavity into an upper chamber and a lower chamber; a DC-DC module and a capacitor assembly, which are both arranged in the lower chamber and abut against the heat dissipation plate; a plurality of module assemblies, which is arranged in the upper chamber and abut against the heat dissipation plate; and a cable interface, which has a main body arranged in the upper chamber and is configured to provide an interface for connection with other module assemblies.

In an embodiment, a length of the upper chamber is greater than that of the lower chamber, so that a rear part of the upper chamber extends beyond the lower chamber. The device further includes a junction box assembly, which is located out of the casing, and in a position behind the lower chamber and thus under a part of the upper chamber extending beyond the lower chamber.

In an embodiment, the upper chamber is further divided into a top part and a bottom part, wherein the cable interface and the module assemblies are located in the bottom part. The device further includes a high-voltage distribution component and a control board component, which are both arranged in the top part.

In an embodiment, the high-voltage distribution component is located at a front section of the top part, while the control board component is located at a rear section of the top part.

In an embodiment, the high-voltage distribution component is configured such that related wires are led out therefrom in a horizontal and/or vertical direction.

In an embodiment, said plurality of module assemblies includes a first module assembly, a second module assembly, a third module assembly, and a fourth module assembly, and the cable interface includes a first three-phase busbar assembly, a second three-phase busbar assembly, and a composite busbar assembly. The first module assembly, the second module assembly and the first three-phase busbar assembly are arranged in a left part of the upper chamber. The third module assembly, the fourth module assembly and the second three-phase busbar assembly are arranged in a right part of the upper chamber. The composite busbar assembly is arranged in a middle part of the upper chamber.

In an embodiment, the lower chamber is configured so that two capacitors can be arranged therein and either one of the capacitors can be removed. The capacitor assembly is configured to work in a mode of single-capacitor or double-capacitor.

In an embodiment, the lower chamber includes three placement positions for capacitor, i.e., a right placement position, a middle placement position, and a left placement position. When two capacitors are arranged in the lower chamber, said two capacitors are arranged at the right and left placement positions, respectively. When only one capacitor is arranged in the lower chamber, the capacitor is arranged in the middle placement position.

In an embodiment, a water pipe of water cooling system is formed in the heat dissipation plate, wherein the water pipe includes a plurality of water inlets/outlets, which are distributed on right and left sides of the heat dissipation plate.

In an embodiment, the water pipe of water cooling system includes three water inlets/outlets, one being located at a left side of the heat dissipation plate while two being located at a right side thereof.

In the device according to the present invention, core components of the electric vehicle are integrated, so that the device has, compared with the prior arts, a compact structure, is small in size and convenient to install and maintain, and has high practical value and promotional value.

Other features or advantages of the present invention will be explained in the following description. In the meantime, some features or advantages of the present invention will become self-evident from the description, or may be understood by implementing the present invention. The objects and some advantages of the present invention can be achieved or obtained through the steps indicated in the description, claims, and drawings.

### Brief Description of the Drawings

The drawings are intended to provide a further understanding of the present invention, and constitute a part of the description. Together with the embodiments of the present invention, the drawings can explain the present invention, but not restrict the present invention in any manner. In the drawings:
Fig. 1 is a side cross-sectional view of a device according to an embodiment of the present invention; and
Fig. 2 is a top cross-sectional view of a device according to an embodiment of the present invention.

### Detailed Description of the Invention

In the following the embodiments of the present invention will be described in detail with reference to the accompanying drawings and examples, so that the procedure concerning how the present invention solves technical problems with technical means to achieve corresponding technical effects can be understood and implemented. It should note that the embodiments of the present application and various features in the embodiments can be combined with each other if there are no conflicts therebetween, and the technical solutions formed by such combinations all fall within the scope of protection of the present invention.

The power control system of an electric vehicle includes many core components. Because these components are independent from each other, they are often arranged at different locations of the vehicle in a stacking manner. This arrangement leads to difficulties of installation and maintenance of these components, and also occupies a huge proportion of vehicle in terms of space and weight. Therefore, the production and assembly of the whole vehicle suffer heavy workload, and thus the production cost is significantly increased. Moreover, various wires are connected between these core components in a criss-cross manner, so that the problem of signal interference is serious due to poor electromagnetic compatibility between these components. Therefore, safe operation of the vehicle is severely affected.

Therefore, a unified and integrated design for the power control system of the vehicle is needed to optimize the layout thereof, by which electromagnetic interference can be mitigated, and the number of the vehicle's parts and components can be reduced. In this manner, most of functional requirements of the vehicle can be met by one single installation of components, the space volume and weight are reduced, the production and maintenance costs are decreased, and the reliability of the vehicle is improved.

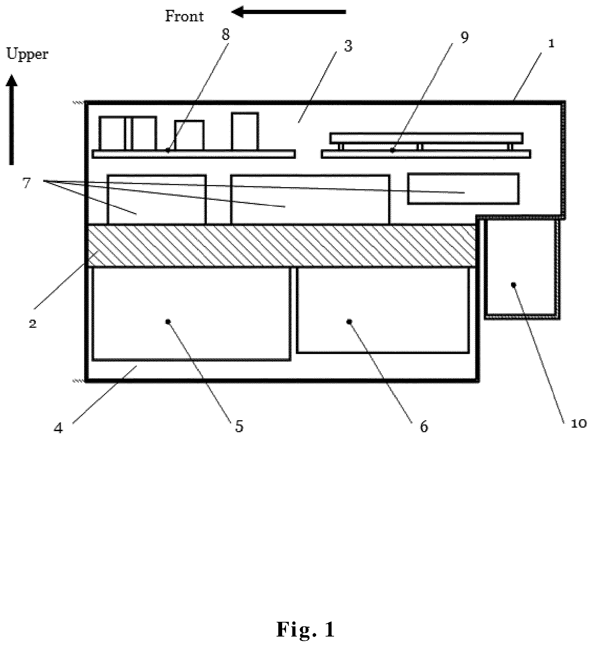

Accordingly, the present invention proposes a control device for a power system of an electric vehicle. As shown in Fig. 1, the device includes a casing 1 that is configured as a box structure with a cavity formed therein, a heat dissipation plate 2 that is arranged in the cavity of the box-shaped casing 1 to divide the cavity into an upper chamber 3 and a lower chamber 4, a DC-DC module 5 and a capacitor assembly 6 that are both arranged in the lower chamber 4 and abut against the heat dissipation plate 2, a plurality of module assemblies 7 that is arranged in the upper chamber 3 and abut against the heat dissipation plate 2, and a cable interface that has a main body arranged in the upper chamber 3 and is configured to provide an interface for connection with other module assemblies.

According to the device of the present invention, the DC-DC module 5, the capacitor assembly 6 and the plurality of module assemblies 7 are arranged to abut against the upper and lower surfaces of the heat dissipation plate 2, respectively, so as to share the heat dissipation plate 2 for heat dissipation. In this manner, the heat dissipation plate 2 can be utilized for heat dissipation to the utmost extent, thereby minimizing the surface area necessary for the heat dissipation plate 2. The arrangement of two chambers according to the present invention provides a small and compact structure. Compared with the unitary arrangement of one single chamber, the volume of the device according to the present invention is reduced by 40%, and the weight thereof is reduced by 50%. Therefore, the compactness inside the device is guaranteed, and the volume of the device is effectively controlled.

Moreover, in one embodiment according to the present invention, the box-shape casing 1 (including the upper chamber 3 and the lower chamber 4) and the intermediate heat dissipation plate 2 are formed into one piece through casting. In this manner, the overall strength of the product is enhanced, and the protection level and the reliability of electromagnetic compatibility of the product are increased. In addition, the number of components and the difficulties in production and assembly are reduced. As a result, the production costs of components are reduced.

Further, the module assembly 7 and the DC-DC module 5 can be integrated with core electrical components and auxiliary electrical components of the power system of the electric vehicle, according to specific needs. In particular, in one embodiment, the module assembly 7 and the DC-DC module 5 include a drive motor controller, a generator controller, an auxiliary inverter power supply for oil pump, an auxiliary inverter power supply for air pump, a DC-DC converter, a vehicle controller, an insulation detector, and a high-voltage distribution unit. The device of the present invention is highly integrated, and can be flexibly configured without affecting the functions of other components. Therefore, on the premise that the functional requirements of the entire vehicle are met, the product costs are minimized.

The device of the present invention is integrated with the core components of the electric vehicle. Compared with the prior arts, the device has a compact structure, small size, and is convenient for installation and maintenance. Therefore, the device has high practical value and promotion value.

Further, in one embodiment, in order to facilitate the wiring of the device, the device further includes a junction box assembly. Considering the expandability of the device, the length of the upper chamber 3 is selected as greater than that of the lower chamber 4, so that the rear part of the upper chamber 3 extends beyond the lower chamber 4, as shown in Fig. 1. The junction box assembly 10 is located out of the casing 1, and in a position behind the lower chamber 4 and thus under a part of the upper chamber 3 extending beyond the lower chamber 4. In this manner, it can be guaranteed that the device has multiple positions for installation of components, and also has a compact space.

The device of the present invention adopts a separate junction box for external electrical interfaces. Without changing the overall size and installation interface of the device, it is convenient to expand and change the electrical interface, so as to meet the requirements of different vehicle models, and to increase the scope and application of the device.

Further, in one embodiment, the upper chamber of the device is further divided into a top part and a bottom part. As shown in Fig. 1, the cable interface and the module assemblies 7 are located in the bottom part. The device further includes a high-voltage distribution component 8 and a control board component 9, which are both arranged in the top part.

Further, in one embodiment, the high-voltage distribution component 8 is located at the front of the top part, while the control board component 9 is located at the rear of the top part. In this manner, the heavy currents are separated from weak currents in the device, and in the meantime the requirements on electromagnetic compatibility are also taken into account. Further, in order to ensure that the wires can be led out of the device in a flexible and diverse manner, the high-voltage distribution component 8 is configured such that related wires can be led out therefrom in a horizontal and/or vertical manner. In this way, the specific manners for leading out the wires can be determined according to actual needs.

Further, in one embodiment, the device includes four module components, and the cable interface of the device includes two three-phase busbar assemblies and a composite busbar assembly.

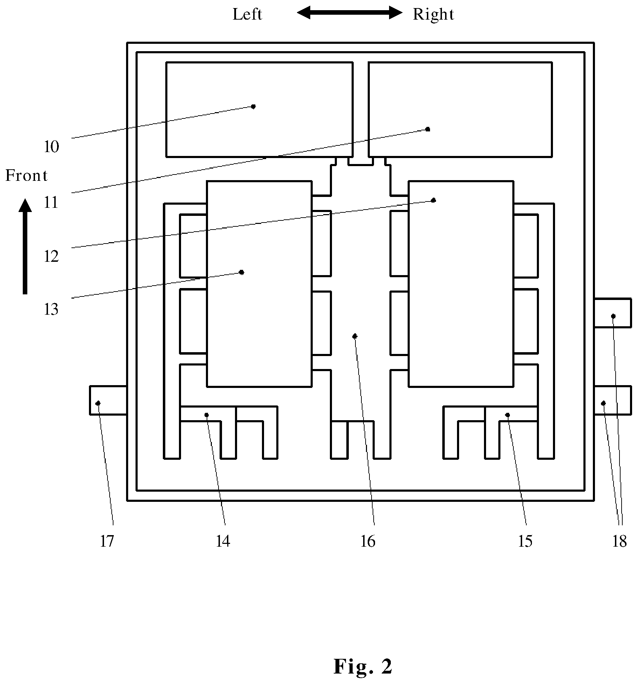

As shown in Fig. 2, the module assembly 10, the module assembly 13 and the three-phase busbar assembly 14 are arranged in the left part of the upper chamber. The module assembly 11, the module assembly 12 and the three-phase busbar assembly 15 are arranged in the right part of the upper chamber. The composite bus bar assembly 16 is arranged in the middle part of the upper chamber.

Further, in an embodiment, the lower chamber is configured so that two capacitors can be arranged therein and either one of the capacitors can be removed. The capacitor assembly is configured to work in a single capacitor mode or in a double capacitor mode. In this way, one capacitor or two capacitors can be selected to be provided according to actual needs. Further, when two capacitors are provided, said two capacitors are completely the same, thus ensuring uniform supply of materials.

Further, in consideration of the central balance of the device, in one embodiment, the lower chamber includes three placement positions for capacitor, i.e., a left one, a middle one and a right one. Among others, when two capacitors are arranged in the lower chamber, said two capacitors are arranged at the right and left placement positions, respectively. When only one capacitor is arranged in the lower chamber, the capacitor is arranged in the middle placement position. In this way, when only one capacitor is provided, unbalance generated when said capacitor is arranged at one side of the lower chamber can be avoided. Specifically, a capacitor mounting interface is provided on each of the left side, the right side, and the middle part of the composite busbar assembly for future use.

Further, in order for heat dissipation, in one embodiment, a water pipe of water cooling system is formed in the heat dissipation plate, wherein the water pipe includes a plurality of water inlets/outlets, which are distributed on the right and left sides of the heat dissipation plate. Because there are water inlets/outlets on the right and left sides of the heat dissipation plate, appropriate water inlets/outlets can be selected according to the internal layout of the vehicle. For example, the water inlets/outlets can be provided at the right side only, the left side only, or both. Therefore, this flexible design of water pipe facilitates the installation of the vehicle's water cooling system, which greatly improves the installation flexibility of the device.

Specifically, as shown in Fig. 2, in an embodiment, the water pipe of water cooling system includes three water inlets/outlets 17, 18, wherein one inlet/outlet 17 is at the left side of the heat dissipation plate while two inlets/outlets 18 are at the right side thereof. Seen from the whole vehicle, there can be two types of water pipe connection, i.e., water inlet/outlet at the right side, or at both sides. In this way, it is convenient for the layout of the whole vehicle.

According to the present invention, on the basis of high degree of internal integration, the fact that the functional requirements on the power system control for different models of vehicles are not completely consistent with each other are sufficiently taken into consideration. Therefore, the present invention adopts a strategy of "breaking up the whole into parts" concerning internal core functional components and higher cost components, so that these components can be arranged flexibly. On the basis of meeting the vehicle's functional and performance requirements, the present invention can reduce the costs of the control device.

Although embodiments of the present invention are disclosed as above, the content as described is only an embodiment adopted for the convenience of understanding the present invention, but not intended to limit the present invention. The present invention may include various other embodiments. Without departing from the spirit of the present invention, those skilled in the art can make various changes or deformations according to the present invention, which should all fall within the scope of protection as claimed by the present invention.

## Claims

1. A control device for a power system of an electric vehicle, including:
a casing, which is configured to have a box structure with a cavity formed therein,
a heat dissipation plate, which is arranged in the cavity to divide the cavity into an upper chamber and a lower chamber,
a DC-DC module and a capacitor assembly, which are both arranged in the lower chamber and abut against the heat dissipation plate,
a plurality of module assemblies, which is arranged in the upper chamber and abut against the heat dissipation plate, and
a cable interface, which has a main body arranged in the upper chamber and is configured to provide an interface for connection with other module assemblies.

2. The device according to claim 1, wherein a length of the upper chamber is greater than that of the lower chamber, so that a rear part of the upper chamber extends beyond the lower chamber, and
the device further includes a junction box assembly, which is located out of the casing, and in a position behind the lower chamber and thus under a part of the upper chamber extending beyond the lower chamber.

3. The device according to claim 1, wherein the upper chamber is further divided into a top part and a bottom part, the cable interface and the module assemblies being located in the bottom part, and
the device further includes a high-voltage distribution component and a control board component, which are both arranged in the top part.

4. The device according to claim 3, wherein the high-voltage distribution component is located at a front section of the top part, while the control board component is located at a rear section of the top part.

5. The device according to claim 4, wherein the high-voltage distribution component is configured such that related wires are led out therefrom in a horizontal and/or vertical direction.

6. The device according to claim 1, wherein said plurality of module assemblies includes a first module assembly, a second module assembly, a third module assembly, and a fourth module assembly, and
the cable interface includes a first three-phase busbar assembly, a second three-phase busbar assembly, and a composite busbar assembly,
wherein the first module assembly, the second module assembly and the first three-phase busbar assembly are arranged in a left part of the upper chamber,
the third module assembly, the fourth module assembly and the second three-phase busbar assembly are arranged in a right part of the upper chamber, and
the composite busbar assembly is arranged in a middle part of the upper chamber.

7. The device according to any one of claims 1 to 6, wherein the lower chamber is configured so that two capacitors can be arranged therein and either one of the capacitors can be removed; and
the capacitor assembly is configured to work in a mode of single-capacitor or double-capacitor.

8. The device according to claim 7, wherein the lower chamber includes three placement positions for capacitor, i.e., a right placement position, a middle placement position, and a left placement position,
wherein when two capacitors are arranged in the lower chamber, said two capacitors are arranged at the right and left placement positions, respectively, and
when only one capacitor is arranged in the lower chamber, said capacitor is arranged in the middle placement position.

9. The device according to any one of claims 1 to 6, wherein a water pipe of water cooling system is formed in the heat dissipation plate, and
the water pipe includes a plurality of water inlets/outlets, which are distributed on right and left sides of the heat dissipation plate.

10. The device according to claim 9, wherein the water pipe of water cooling system includes three water inlets/outlets, one being located at a left side of the heat dissipation plate while the other two being located at a right side thereof.
